Europäisches Patentamt

European Patent Office

Office européen des brevets

(19)

(11) Veröffentlichungsnummer: **0 002 496**
**B1**

(12) **EUROPÄISCHE PATENTSCHRIFT**

(45) Veröffentlichungstag der Patentschrift: **26.05.82**

(21) Anmeldenummer: **78101588.8**

(22) Anmeldetag: **07.12.78**

(51) Int. Cl.³: **H 05 K 13/02,**
**B 65 G 47/24,**
**B 65 G 47/91,**
**H 01 L 21/68, H 05 K 13/00**

(54) Verfahren und Vorrichtung zum Ausrichten flacher dünner Werkstücke.

(30) Priorität: **12.12.77 US 859777**

(43) Veröffentlichungstag der Anmeldung:
**27.06.79 Patentblatt 79/13**

(45) Bekanntmachung des Hinweises auf die Patenterteilung:
**26.05.82 Patentblatt 82/21**

(84) Benannte Vertragsstaaten:
**DE FR GB**

(56) Entgegenhaltungen:
**DE - A - 2 047 719**
**DE - A - 2 451 549**
**DE - A - 2 520 201**
**DE - A - 2 542 047**
**DE - A - 2 643 277**
**DE - A - 2 738 989**

(73) Patentinhaber: **International Business Machines**
**Corporation**
**Armonk, N.Y. 10504 (US)**

(72) Erfinder: **Ficker, Walter William**
**17 Birch Street**
**Fishkill New York 12524 (US)**
Erfinder: **Lonser, David E.**
**3315 NE 31st Avenue**
**Light House Point Florida 33064 (US)**
Erfinder: **Rance, William Glenn**
**9401 Placita Lila**
**Tucson, Arizona 85715 (US)**
Erfinder: **Stricker, Alfred Alois**
**1903 Bay Drive**
**Pompano Beach Florida 33062 (US)**
Erfinder: **Vonkaenel, Walter**
**510 SE 13th Street**
**Pompano Beach Florida (US)**

(74) Vertreter: **Willich, Wolfgang, Dipl.-Ing.**
**Schönaicher Strasse 220**
**D-7030 Böblingen (DE)**

Courier Press, Leamington Spa, England.

## Verfahren und Vorrichtung zum Ausrichten flacher dünner Werkstücke

Die Erfindung betrifft ein Verfahren und eine Vorrichtung zum Ausrichten eines flacher dünner Werkstücks, z. B. einer Platte, eines Folienelementes und dgl.

Die Verarbeitung derartiger Folienelemente spielt insbesondere in der Herstellung von mehrschichtigen keramischen Halbleiterpackungen eine wichtige Rolle. Bei dieser Art Halbleiterpackungen können innerhalb des Substrates verschiedene, aus Komponenten und Leitungsmustern bestehende Schaltungen untergebracht werden, und es besteht außerdem die Möglichkeit, auch sehr komplexe Schaltungsanordnungen herzustellen, wie sie mit den bisher bekannten Techniken des Auftragens einer Mehrzahl metallischer Schichten auf das Substrat nicht erreichbar waren.

Die Herstellung mehrschichtiger keramischer Halbleiterpackungen erfolgt dadurch, daß man zunächst eine Mischung aus fein verteiltem keramischen Material, einem flüchtigen Lösungsmittel und einer Trägermasse bildet. Diese Mischung wird mit Hilfe eines Abstreichmessers oder einer Rakel zu einer dünnen Schicht ausgestrichen und zum Austreiben des flüchtigen Lösungsmittels getrocknet. Das ergibt eine dünne, biegsame papierähnliche Folie, üblicherweise als grüne keramische Folie bezeichnet. Diese Folie wird in kleinere Stücke zerschnitten und durch Herstellen von durchgehenden Bohrungen, Ausfüllen dieser Bohrungen mit einer elektrisch leitenden Paste und Aufdrucken eines Leitungsmusters weiter verarbeitet. Eine Anzahl derartig verarbeiteter Folienelemente wird dann zusammengefügt, gepreßt, geschnitten und anschließend bei relativ hoher Temperatur gesintert. Während dieses Sintervorganges werden die Trägermasse und noch verbleibende Bindemittel ausgebrannt, so daß ein starrer keramischer Körper entsteht, der in seinem Innern miteinander verbundene Leitungsmuster aufweist. Dann werden auf die Oberseite und die Unterseite des keramischen Substrates entsprechende Matellisierungen aufgebracht und die entsprechenden Verbindungen über die zuvor in den Folienelementen hergestellten durchgehenden Bohrungen hergestellt. Anschließend werden die elektrischen Anschlüsse und Halbleitervorrichtungen angebracht und das ganze eingekapselt.

Die Verarbeitung der einzelnen Folienelemente in der oben beschriebenen Art bereitet erhebliche Schwierigkeiten, insbesondere deshalb, weil die Folienelemente bei einer Dicke von etwa 0,2 mm relativ brüchig und im Vergleich zu ihrer Dicke sehr groß sind. Außerdem muß das Ausrichten der Folienelemente mit der Maske zur Herstellung der gewünschten Leitungsmuster und zum Ausfüllen der durchgehenden Bohrungen sehr sorgfältig durchgeführt werden, wozu man üblicherweise nahe den Kanten der Folienelemente befindliche Ausrichtlöcher verwendet. Wird das Folienelement über die Ausrichtlöcher aufgelegt, muß darauf geachtet werden, daß die Ausrichtlöcher nicht beschädigt und die Folienelemente nicht verzogen werden. Die bekannten Verfahren zum Bedrucken von Leitungsmustern auf starren Substraten gaben keine Lösung für die Bewältigung dieser Schwierigkeiten an, da die bisher verwendeten Substrate entweder starre, aus Tonerde bestehende Modulsubstrate oder aus Kunstharz bestehende Schaltungskarten waren; denn bei diesen Anwendungsgebieten ließ sich wie es durch die DE—A 25 42 047 bekannt ist, das Ausrichten eines plattenförmigen Werkstücks in einer Lage parallel zu einer Referenzfläche durch Anlegen an Anschlagflächen erreichen. Hierbei werden die Ecken oder unter einem bestimmten Winkel zueinander ausgerichtete Kanten des Werkstücks als Bezugsflächen verwendet. Dieses Verfahren kann aber bei Folienelementen nicht angewendet werden.

In der DE—A 27 38 989 ist eine Vorrichtung zum Ausrichten von Folienelementen beschrieben, bei der die auf einen beweglichen Träger aufgespannte Folie zunächst in waagrechter und dann durch die Keilwirkung zweier komplementärer keilförmiger Platten in senkrechter Richtung zu einer Druckstation verfahren und an Anschlägen ausgerichtet wird. Diese Methode ist jedoch wegen der erforderlichen manuellen Handhabung mit gewissen Mängeln behaftet, und zwar insbesondere wegen der Gefahr der Beschädigung der Folienelemente oder der darauf befindlichen leitenden Muster. Es besteht daher die Aufgabe, die Ausrichtung derartiger Folienelemente, sogenannter grüner keramischer Folien, auf vollständig automatische Weise so durchzuführen, daß eine manuelle Handhabung nicht erforderlich ist und auch bei der automatischen Handhabung der Folienelemente eine Beschädigung irgendwelcher Art ausgeschlossen ist. Diese Aufgabe wird durch das im Patentanspruch 1 angegebene Verfahren gelöst.

Durch die DE—A 25 20 201 ist zwar eine Vorrichtung zum Positionieren von flachen Vorlagen, z. B. in Geräten zur photographischen Reproduktion von Bildern, bekannt, bei der gleichfalls Richtelemente in Form von beweglichen Stiften zum Ausrichten Verwendung finden, jedoch handelt es sich hier um eine Anordnung, bei der die Werkstücke auf einer horizontalen Führungsbahn zugeführt werden. Dort bietet sich somit ohne weiteres die Möglichkeit, von der Oberseite eine Platte mit entsprechenden Richtstiften zuzuführen. Beim erfindungsgemäßen Verfahren werden hingegen die einzelnen Werkstücke in der Ausrichtstation von der Oberseite zugeführt und auf den Gasfilm der als Ablagefläche benutzten Referenzfläche abgesetzt.

Eine besonders geeignete Vorrichtung zur Ausführung des Verfahrens nach Patentanspruch 1 mit einer Fördervorrichtung zur zufuhr des Werkstücks zu einer Richtstation sowie zur Entnahme des ausgerichteten, auf der Referenzfläche der Richtstation aufliegenden Werkstücks zeichnet sich dadurch aus, daß aus der als Auflagefläche dienenden Referenzfläche der Richtstation ausfabrbare bzw. in diese zurückziehbare Richtstifte angeordnet sind und daß unterhalb der Referenzfläche eine mit Überdruck beaufschlagbare Kammer vorgesehen ist, wobei der Überdruck zur Bildung des Gasfilms dient.

Von besonderem Vorteil ist es, wenn die Fördervorrichtung eine Platte mit einer in der Führungsfläche der Platte angeordneten, wahlweise auf Unterdruck und Überdruck umschaltbaren Kammer aufweist, welche Platte mittels eines horizontalen Antriebes und eines Hubantriebes zur Referenzfläche ausrichtbar und in Richtung der Normalen, zur Referenzfläche verstellbar ist. Die Anordnung je einer Kammer zur Anschaltung an Unterdruck oder Überdruck sowohl in der Platte der Fördervorrichtung als auch in der Platte mit der Referenzfläche bietet den Vorteil, daß das Folienelement zunächst, mittels Untendruck an der Platte der Fördervorrichtung haftend, zugeführt werden kann; durch Umschaltung auf Überdruck sowohl in der Platte der Fördervorrichtung als auch in der Platte der Referenzfläche wird sodann beiderseits des Folienelements ein Gasdruckfilm gebildet, der ein widerstandsfreies Ausrichten des Elements ermöglicht. Nach dem Ausrichten wird die Kammer in der Referenzfläche auf Unterdruck umgeschaltet, so daß das Folienelement nun mit physischem Kontakt auf die Referenzfläche aufgelegt wird und die Ausrichtmittel, z. B. Richtstifte, unwirksam gemacht bzw. Zurückgezogen werden können.

Die Erfindung wird im folgenden an Hand der Zeichnungen in einem Ausführungsbeispiel beschrieben. Es zeigen:

Fig. 1 in schaubildlicher Darstellung eine Gesamtanordnung einer Vorrichtung zum Transport und zum Ausrichten von Folienelementen,

Fign 2 bis 4 schematische Darstellungen des Ausrichtvorganges in der Ausrichtstation gemäß Fig. 1, in aufeinanderfolgenden Phasen und,

Fig. 5 eine schematische, schaubildliche Darstellung der Antriebsvorrichtung für die Richtstifte der Ausrichtstation gemäß den Fign. 1 bis 4.

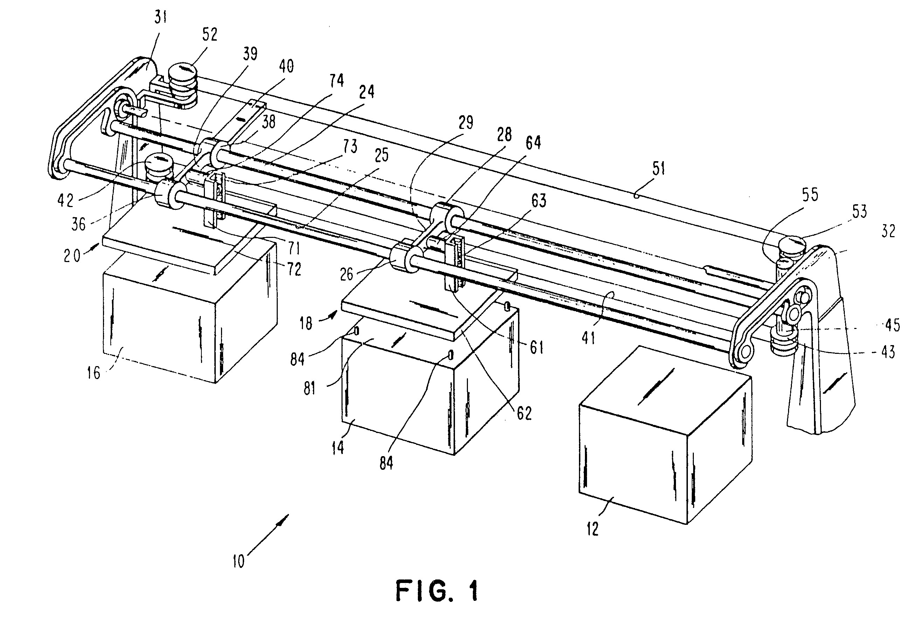

Die in Fig. 1 dargestellte Transporteinrichtung 10 besteht aus einer Eingabestation 12, einer Ausrichtstation 14 und einer Ausgabestation 16. Eine Eingabefördervorrichtung 18 ist zwischen der Eingabestation 12 und der Ausrichtstation 14 beweglich, und eine Ausgabefördervorrichtung 20 ist zwischen der Ausrichtstation 14 und der Ausgabestation 16 verfahrbar. Zu den Eingabe- und Ausgabefördervorrichtungen 18 und 20 gehören Schienen 24 und 25, die in Trägern 31 und 32 gelagert sind und quer über die vorgenannten Stationen verlaufen.

Die Eingabefördervorrichtung 18 ist zu ihrer bewegung zwischen der Eingabestation und der Ausrichtstation 14 auf den Schienen 24 und 25 mit Führungsbuchsen 26 und 28 versehen, die mittels eines Joches 29 untereinander verbunden sind. In entsprechender Weise weist die Ausgabefördervorrichtung 20 Führungsbuchsen 36 und 38 auf, die gleichfalls auf den Schienen 24 und 25 längsbeweglich geführt und mittels eines Joches 39 untereinander verbunden und zur Halterung der Ausgabefördervorrichtung 20 vorgesehen sing.

Zum Antrieb der Eingabefördervorrichtung 18 längs der Schienen 24 und 25 dient ein Seilzug 41, der beiderseits am Joch 29 befestigt und über Umlenkrollen 42 und 43 geführt ist. Ein Elektromotor 45 ist über die umlenkrolle 43 auf den Seilzug 41 zum Antrieb der Eingabefördervorrichtung 18 wirksam.

In der gleichen Weise, wie zuvor in Bezug auf die Eingabefördervorrichtung 18 beschrieben, wird auch die Ausgabefördervorrichtung 20 mittels eines Seilzuges 51, welcher über Umlenkrollen 52 and 53 geführt ist, von einem Elektromotor 55 angetrieben. Die Enden des Seilzuges 51 sind an einem Arm 40 des Joches 39 befestigt.

Zur vertikalen Verstellbewegung der Eingabefördervorrichtung 18 ist eine Zahnstange 61 an einer Platte 62 befestigt, und mit der Zahnstange 61 wirkt ein Ritzel 63 zusammen, welches am Joch 29 gelagert ist und mittels eines Elektromotors 64 angetrieben wird. Der Vertikalantrieb für die Ausgabefördervorrichtung 20 in Bezug auf die Ausrichtstation 14 und die Ausgabestation 16 weist in gleicher Ausführung eine Zahnstange 71 an einer Platte 72 auf, mit der ein von einem Elektromotor 74 angetriebenes Ritzel 73 zusammenwirkt.

Wie weiterhin Fig. 1 zeigt, bildet die Eingabestation 12 eine flache Oberfläche zur Aufnahme von auszurichtenden Folienelementen. Wenn erforderlich, kann die Eingabestation 12 mit einer Trägerplatte oder einem anderen Trägerelement zur Aufnahme der Folienelemente ausgestattet werden. Das gleiche gilt für die Ausgabestation 16 in Bezug auf die Aufnahme der nun ausgerichteten Folienelemente, für den nachfolgenden Transport zur anderen Stationen zum Zwecke des Aufeinanderschichtens oder anderer Bearbeitungsvorgänge.

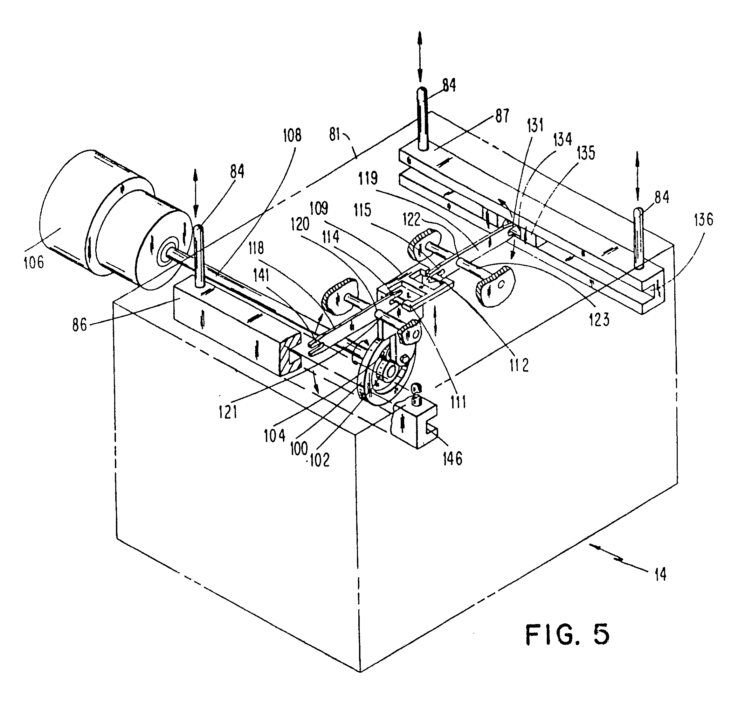

Die Ausrichtstation 14 weist eine Referenzfläche 81 auf, aus deren Eckbereichen bewegliche Richtstifte 84 herausragen. Die Richtstifte 84 dienen zum Einführen in entsprechende Löcher der auszurichtenden Folienelemente und sind bezüglich der Referenzfläche 81 mittels einer in Fig. 5 dargestellten Antriebseinrichtung vertikal bewegbar.

Wie Fig. 5 zeigt, sind die Richtstifte 84 auf der Oberseite von Schienen 86, 87 befestigt.

Die Schienen 86, 87 befinden sich unterhalb der Referenzfläche 81, und die Richtstifte 84 ragen durch entsprechende Bohrungen in der Referenzfläche 81 hindurch zur Zusammenwirkung mit den auszurichtenden Folienelementen. In ihrer unteren Stellung befinden sich die Richtstifte 84 unterhalb der Referenzfläche 81.

Die Antriebsvorrichtung zum Anheben und Absenken der Richtstifte 84 enthält eine Nockenscheibe 100 mit einer Nockenfläche 102 und einer damit zusammenwirkenden Nockenfolgerolle 104. Die Nockenscheibe 100 wird von einem Motor 106 über eine Welle 108 angetrieben. Die Nockenfolgerolle 104 ist an einer abgewinkelt ausgebildeten Nockenfolgeplatte 109 befestigt, die demnach bei umlaufendem Motor 106 vertikale Vor- und Rückhubbewegungen ausführt. An der Nockenfolgeplatte 109 befinden sich Stege 111 und 112, mit denen Gabelstücke 114 bzw. 115 an Antriebsarmen 118 bzw. 119 formschlüssig gekoppelt sing. Der Antriebsarm 118 ist gelenkig am Drehpunkt 120 einer Achse 121 gelagert, während der Antriebsarm 119 in entsprechender Weise an einem Drehpunkt 122 einer Achse 123 geführt ist.

Das äußere Ende des Antriebsarms 119 ist mit einem Gabelstück 131 versehen, das mit einem Bolzen 134 im Eingriff steht, welcher seinerseits in einem in einer Nut 136 der schiene 87 geführten Lagerkopf 135 geführt ist. In entsprechender Weise befindet sich am äußeren Ende des Antriebsarms 118 ein Gabestück 141, zum Eingriff mit einem (nicht gezeigten) Bolzen und Lagerkopf in der Nut 146 der Schiene 86.

Zur Betätigung der in Fig. 5 gezeigten Anordnung führen bei Einschaltung des Motors 106 die Welle 108 und mit ihr die Nockenscheibe 100 und die Nockenfläche 102 eine Drehbewegung aus, mit der Folge, daß über die Nockenfolgerolle 104 die Nockenfolgeplatte 109 eine Aufwärts- bzw. Abwärtsbewegung ausführt. Diese Bewegung der Nockenfolgeplatte 109 wird auf die Antriebsarme 118, 119 übertragen, und infolgedessen führen die Schienen 86 und 87 eine entgagengerichtete Vertikalbewegung aus. Das Anheben der Nockenfolgeplatte 109 hat somit ein Absenken der Richtstifte 84 zur Folge, und umgekehrt werden die Richtstifte 84 in ihre ausgefahrene Stellung verstellt, wenn die Nockenfolgeplatte 109 eine Abwärtsbewegung ausführt.

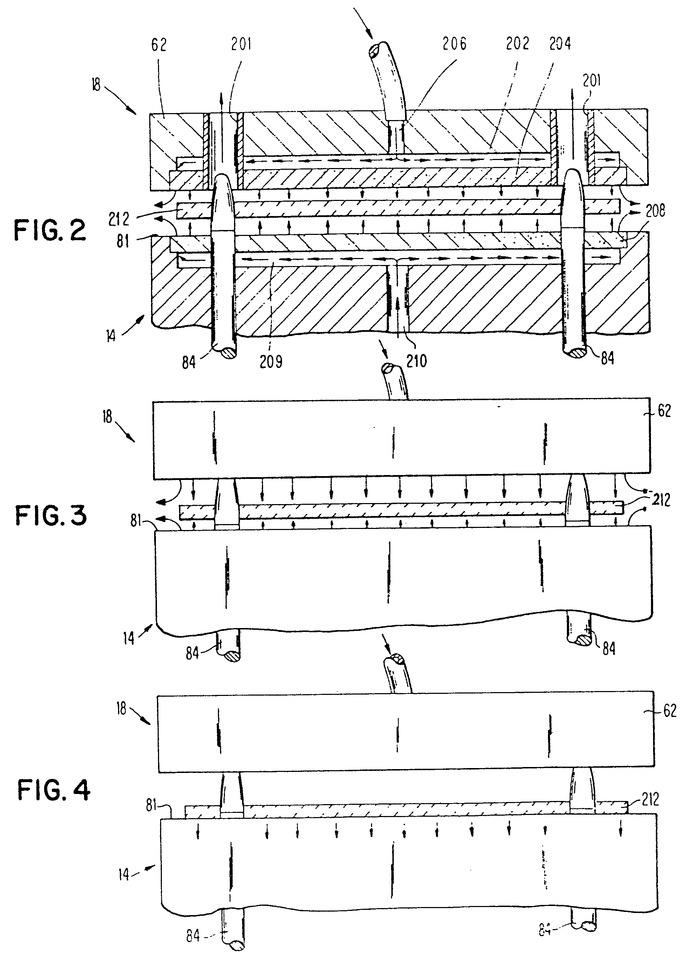

Gemäß Fig. 2 ist die Platte 62 der Eingabefördervorrichtung 18 mit Bohrungen 201 in ihren Ecken zur Aufnahme der Richtstifte 84 in deren ausgefahrener Stellung versehen. In der Platte 62 ist weiterhin eine Kammer 202 gebildet, welche gegen die untere Fläche der Platte 62 durch eine poröse Platte 204 verschlossen ist. Die Kammer 202 ist über einen Kanal 206 mit einem (nicht dargestellten) Überdruck-/Unterdruck-system verbunden, so daß die Kammer 202 wahlweise mit Überdruck oder Unterdruck beaufachlagbar ist.

Wie Fig. 2 weiter zeigt, ist die Referenzfläche 82 gleichfalls durch eine poröse Platte 208 abgedeckt, durch welche eine Kammer 209 gebildet ist. Diese Kann über einen Kanal 210 gleichfalls mit Überdruck oder mit Unterdruck beaufschlagt werden. Wie bereits erwähnt, sing die Stifte 84 beweglich geführt und können aus der Referenzfläche 81 ausgefahren werden, so daß sie aus dieser herausragen.

Der erste Arbeitsschritt zur Ausrichtung eines Folienelements besteht darin, die Eingabefördervorrichtung 18 mit der Platte 62 auf die Eingabestation 12 auszurichten und auf die Trägerplatte mit dem Folienelement oder einer mehrschichtigen Folienanordnung abzusenken. Durch Anlegen von Unterdruck an die Kammer 202 wird sodann das Folienelement angezogen, und anschließend wird die Eingabefördervorrichtung 18 angehoben und längs den Schienen 24 und 25 zur Ausrichtstation 14 bewegt.

Nun wird die Platte 62 auf die Referenzfläche 81 der Ausrichtstation 14 abgesenkt, und während sie sich der Referenzfläche 81 nähert, wird die Kammer 209 mit Druckluft beaufschlagt (vergl. Fig. 2). Gleichzeitig wird in der Kammer 202 von Unterdruck auf Überdruck umgeschaltet, mit der Folge, daß nun sowohl von der Oberseite als auch von der Unterseite ein Druckluftfilm auf das Folienelement 12 wirksam ist. Der beiderseits wirksame Luftdruck wird hierbei so bemessen, daß sich das Folienelement 212 in einer stabilen Lage "schwimmend" zwischen den porösen Platten 204 und 208 befindet. Werden nun die Richtstifte 84 aus der Referenzfläche 81 ausgefahren, so bewirken diese infolge der abgerundeten Gestaltung ihrer Spitzen beim Erreichen der entsprechenden Löcher im Folienelement 212 eine Korrektur der Lage des Folienelements, wenn die Lage der Löcher nicht genau mit derjenigen der Richtstifte 84 übereinstimmt. Eine derartige Korrektur der Lage des Folienelements 212 erfolgt infolge der schwimmenden Lagerung des Folienelements widerstandsfrei. Unter der Voraussetzung einer genauen Übereinstimmung der Abstände der Richtstifte 84 einerseits und der Abstände der Löcher im Folienelement andererseits ist daher eine Beanspruchung des Folienelements oder eine Beschädigung desselben im Verlauf des Ausrichtvorganges ausgeschlossen. Darüber hinaus gewährleisten die Druckzonen unterhalb und oberhalb des Folienelements dessen ebene Führung, so daß kein Durchhängen des Zentralbereiches mit den daraus resultierenden Nachteilen befürchtet werden muß.

Sind die Richtstifte 84 ausgefahren und der Ausrichtvorgang beendet, so wird der Überdruck in der Kammer 209 abgestellt, oder die Differenz des druckes oberhalb des Folienelements und unterhalb des Folienelements so bemessen, daß das Folienelement auf der Referenzfläche 81 zu liegen kommt. Dieser Vorgang kann unterstützt werden durch eine entsprechende weitere Abwärtsbewegung der Eingabefördervorrichtung 18. Wenn das Folienelement 212 auf der Referenzfläche 81 aufliegt, wird die Eingabefördervorrichtung 18 wieder angehoben und zur Eingabestation 12 zurückgefahren, wo sie ein weiteres Folienelement aufnehmen kann.

Gleichzeitig wird die Ausgabefördervorrichtung 20 zur Ausrichtstation 14 bewegt und auf das Folienelement ausgerichtet, und sodann wird die Platte 72 auf das Folienelement abgesenkt. Nun wird die Ausgabe förder vorrichtung 20 mit Unterdruck beaufschlagt, wieder angehoben und zur Ausgabestation 16 bewegt, wo das betreffende Folienelement, ggf. auf dort bereits ausgerichtet aufliegende weitere Folienschichten, abgelegt wird.

## Patentansprüche

1. Verfahren zum Ausrichten eines flachen dünnen Werkstücks, z. B. einer Platte, eines Folienelements und dgl., welches zunächst in eine Lage parallel zu einer Referenzfläche befördert und mit geringem Abstand zu dieser auf einem Gasfilm berührungsfrei gelagert wird, dadurch gekennzeichnet, daß während der Wirksamkeit des Gasfilms aus der Referenzfläche ausfahrbare bzw. in diese zurückziehbare Richtelemente in korrespondierende Öffnungen im Werkstück ausgefahren werden, daß das Werkstück sodann durch Verringerung des Überdrucks in physischen Kontakt mit der als Auflagefläche dienenden Referenzfläche gebracht wird, und daß anschließend die Richtelemente zurückgezogen und dadurch außer Eingriff mit dem Werkstück gebracht werden.

2. Vorrichtung zur Ausführung des Verfahrens nach Patentanspruch 1, mit einer Fördervorrichtung (18, 20) zur Zufuhr des Werkstücks (212) zu einer Richtstation (14) sowie zur Entnahme des ausgerichteten, auf der Referenzfläche (81) der Richtstation (14) aufliegenden Werkstückes (212), dadurch gekennzeichnet, daß aus der als Auflagefläche dienenden Referenzfläche (81) der Richtstation (14) ausfahrbare bzw. in diese zurückziehbare Richtstifte (84) angeordnet sind und daß unterhalb der Referenzfläche (81) eine mit Überdruck beaufschlagbare Kammer (209) vorgesehen ist, wobei der Überdruck zur Bildung des Gasfilms dient.

3. Vorrichtung nach Anspruch 2, dadurch gekennzeichnet, daß die Fördervorrichtung (18; 20) eine Platte (62; 72) mit einer in der Führungsfläche der Platte (62; 72) angeordneten, wahlweise auf Unterdruck und Überdruck umschaltbaren Kammer (202; 209) aufweist, welche Platte mittels eines Horizontalantriebes (36, 38 bis 43, 45; 51 bis 53, 55) und eines Hubantriebes (61 bis 64; 71 bis 74) zur Referenzfläche (81) ausrichtbar und in Richtung der Normalen zur Referenzfläche (81) verstellbar ist.

4. Vorrichtung nach Anspruch 3, dadurch gekennzeichnet, daß der Horizontalantrieb für die Platte als auf Schienen (24, 25) mittels Führungsbuchsen (26, 28; 36, 38) verschiebbares Joch (29; 39) mit Seilzugantrieb (41 bis 43, 45; 51 bis 53, 55) ausgebildet ist.

5. Vorrichtung nach den Ansprüchen 3 und 4, dadurch gekennzeichnet, daß der Hubantrieb der Platte (62; 72) als an dem Joch (39; 39) angeordneter Zahnstangenantrieb (61 bis 64; 71 bis 74) ausgebildet ist.

6. Vorrichtung nach den Ansprüchen 2 und 3, dadurch gekennzeichnet, daß die Führungsfläche der Platte (62; 72) als zwischen Kammer (202; 209) und Plattenoberfläche angeordnete poröse Platte (204; 208) ausgebildet ist.

7. Vorrichtung nach Anspruch 2, dadurch gekennzeichnet, daß zur Betätigung der Richtstifte (84) ein auf parallel geführte, die Richtstifte (84) tragende Schienen (86, 87) wirksamer motorgetriebener Nockenantrieb (100 bis 124) vorgesehen ist.

8. Vorrichtung nach Anspruch 7, dadurch gekennzeichnet, daß der Nockenantrieb eine mit einer Nockenscheibe (100) zusammenwirkende Nockenfolgeplatte (109) aufweist, mit deren Stegen (111, 112) Gabelstücke (114, 115) in drehbar gelagerten, andererseits mit den Schienen (86, 87) verbundenen Antriebsarmen (118, 119) gekoppelt sind.

## Revendications

1. Procédé pour aligner une pièce mince et plate, par exemple une plaque, une feuille, etc., qui est d'abord amenée dans une position parallèle à une surface de référence et qui est supportée par un film de gaz à une faible distance de cette surface, caractérisé en ce que, lorsque le film de gaz est actif, des éléments d'alignement pouvant être insérés dans, ou retirés de, la surface de référence sont placés dans des ouvertures correspondantes de la pièce, en ce que, par diminution de la pression, la pièce est mise en contact physique avec la surface de référence servant de support, et en ce que finalement les éléments d'alignement sont retirés et libèrent ainsi la pièce.

2. Dispositif pour exécuter le procédé selon la revendication 1, comportant un dispositif de transport (18, 20) pour amener la pièce (212) à une station d'alignement (14) et pour enlever la pièce alignée (212) positionnée sur la surface de référence (81) de la station d'alignement (14), caractérisé en ce qu'il comporte des broches d'alignement (84) pouvant se retirer ou pénétrer dans la surface de référence (81) servant de support de la station d'alignement (14), et en ce qu'il est prévu, en-dessous de la surface de référence (81), une chambre (209) dans laquelle une pression peut être appliquée, cette pression étant utilisée pour former ledit film de gaz.

3. Dispositif selon la revendication 2 caractérisé en ce que le dispositif de transport (18; 20) comporte une plaque (62; 72) avec une chambre (202; 209) disposée sur la face de guidage de la plaque (62; 72) et pouvant être sélectivement soumise à une dépression ou à une pression, ladite plaque pouvant être, à l'aide d'un entraînement horizontal (36, 38 à 43, 45; 51 à 53, 55) et d'un entraînement d'élévation (61 à 64; 71 à 74), alignée par rapport à la surface de référence (81) et ajustée dans la direction de la normale par rapport à la surface de référence (81).

4. Dispositif selon la revendication 3, caractérisé en ce que l'entraînement horizontal pour la plaque est conçu comme une traverse (29; 39) pouvant être déplacée sur des rails (24, 25) à l'aide de douilles de guidage (26, 28; 36, 38) avec une commande par poulie à câble (41 à 43, 45; 51 à 53, 55).

5. Dispositif selon les revendications 3 et 4, caractérisé en cen que la commande d'élévation de la plaque (62; 72) forme une commande à crémaillère et pignon (61 à 64; 71 à 74) disposée sur la traverse (29; 39).

6. Dispositif selon les revendications 2 et 3, caractérisé en ce que la surface de guidage de la plaque (62, 72) forme une plaque poreuse (204; 208) disposée entre la chambre (202; 209) et la surface de la plaque.

7. Dispositif selon la revendication 2, caractérisé en ce que, pour actionner les broches d'alignement (84), il comporte un entraînement à came (100 à 124) actionné par moteur, qui fonctionne sur des rails (86, 87) parallèles supportant les broches d'alignement (84).

8. Dispositif selon la revendication 7, caractérisé en ce que ledit entraînement à came comporte une plaque suiveuse de came (109) coopérant avec un disque à came (100), les ponts (111, 112) de cette plaque étant couplés à des segments de fourche (114, 115) réalisés dans des bras d'entraînement (118, 119) montés en rotation, dont l'autre extrémité est connectée aux rails (86, 87).

**Claims**

1. Method of aligning a flat, thin element, e.g. a plate, a foil etc., which first is positioned in parallel to a reference surface and suspended, at a small distance from that surface, over a gas film, characterized in that while the gas film is maintained alignment pins that can be moved into and out of the reference surface are inserted into corresponding openings in the element, that subsequently, by reducing the overpressure, the element is brought into physical contact with the reference surface acting as a support, and that the alignment units are then withdrawn and thus disengaged from the element.

2. Device for carrying out the method as claimed in claim 1, comprising a transport device (18, 20) to transport the element (212) to an alignment station (14) and to remove the aligned element (212) positioned on the reference surface (81) of the alignment station (14), characterized in that alignment pins (84) are provided that can be moved into and out of the reference surface (81) of the alignment station (14) that is used as a support, and that under the reference surface (81) a chamber (209) that can be applied with overpressure is provided, the overpressure being used to produce the gas film.

3. Device as claimed in claim 2, characterized in that the transport device (18; 20) comprises a plate (62; 72) with a chamber (202; 209) arranged in the guide face of the plate (62; 71) and selectively switchable to underpressure and overpressure, which plate, by means of a horizontal drive (36, 38 to 43, 45; 51 to 53, 55) and a stroke drive (61 to 64; 71 to 74), is alignable to the reference surface (81) and adjustable in the direction of the normal to the reference surface (81).

4. Device as claimed in claim 3, characterized in that the horizontal drive for the plate is designed as a yoke (29; 39) shiftable on rails (24, 25) by means of guide bushings (26, 28; 36, 38), with a pulley drive (41 to 43, 45; 51 to 53, 55).

5. Device as claimed in claims 3 and 4, characterized in that the stoke drive of the plate (62; 72) is designed as a rack drive (61 to 64; 71 to 74) arranged at the yoke (29; 39).

6. Device as claimed in claim 2 and 3, characterized in that the guide surface of the plate (62, 72) is designed as a porous plate (204; 208) arranged between chamber (202; 209) and plate surface.

7. Device as claimed in claim 2, characterized in that for operating the alignment pins (84) a cam drive (100 to 124) is provided which acts on parallel bars (86, 87) carrying the alignment pins (84).

8. Device as claimed in claim 7, characterized in that the cam drive comprises a cam follower plate (109) co-acting with a cam disk (100), the cam follower plate having coupled to its horizontal flanges (111, 112) fork portions (114, 115) in rotatable supported drive arms (118, 119) connected on their other side with the bars (86, 87).

FIG. 1

FIG. 2

FIG. 3

FIG. 4

0 002 496

FIG. 5

3